# DEMANDE DE BREVET EUROPEEN

(11) **EP 2 263 971 A1**
(43) Date de publication de la demande: **22.12.2010**
(21) Numéro de dépôt: 09162292.8
(22) Date de dépôt: 09.06.2009
(51) Int. Cl.: B81C 99/00, B29C 33/38, C25D 1/10

(54) **Pièce de micromécanique composite et son procédé de fabrication**

(71) Demandeur: Nivarox-FAR S.A., CH-2400 Le Locle (CH)
(72) Inventeur: Cusin, Pierre, 1423, Villars-Burquin (CH); Thiébaud, Jean-Philippe, 1588, Cudrefin (CH)
(74) Mandataire: Couillard, Yann Luc Raymond

(57) **Abrégé**

L'invention se rapporte à un procédé de fabrication (1) d'une pièce de micromécanique composite (41, 41') comportant les étapes suivantes :
a) se munir (10) d'un substrat (9, 9') comportant une couche supérieure (21) et une couche inférieure (23) en matériau micro-usinable électriquement conductrices et solidarisées entre elles par une couche intermédiaire (22) électriquement isolante ;
b) graver selon au moins un motif (26) dans la couche supérieure (21) jusqu'à la couche intermédiaire (22) afin de former au moins une cavité (25) dans le substrat (9, 9') ;
c) recouvrir (16) la partie supérieure dudit substrat d'un revêtement (30) électriquement isolant ;
d) graver (18) de manière directionnelle ledit revêtement et ladite couche intermédiaire afin de limiter leur présence uniquement au niveau de chaque paroi verticale (51, 52) formée dans ladite couche supérieure ;
e) réaliser (5) une électrodéposition en connectant l'électrode à la couche conductrice inférieure (23) du substrat (9, 9') afin de former au moins une partie métallique (33, 43, 43') de ladite pièce ;
f) libérer la pièce composite (41, 41') du substrat (9, 9').

L'invention concerne le domaine des pièces de micromécanique notamment pour des mouvements horlogers.

## Description

### Domaine de l'invention

L'invention se rapporte à une pièce de micromécanique composite dont au moins une face est à faible coefficient de frottement ainsi que son procédé de fabrication.

### Arrière plan de l'invention

Le document EP 2 060 534 divulgue un procédé de fabrication d'une pièce de micromécanique composite en silicium et métal obtenue à partir de photolithographies de résines photosensibles, de gravages de silicium et de croissances galvaniques. Cependant, un tel procédé est complexe à mettre en oeuvre pour des parties en métal sur plusieurs niveaux et il est nécessaire de prévoir des étapes finales de revêtement pour améliorer les caractéristiques tribologiques du silicium.

De plus, un tel procédé n'est pas adapté pour des pièces de micromécanique à grand élancement où un matériau tel que le nickel - phosphore à, par exemple, 12% de phosphore à tendance au décollement. En effet, les dépôts galvaniques de ce type de pièces délaminent en raison des contraintes internes du nickel - phosphore déposé.

### Résumé de l'invention

Le but de la présente invention est de pallier tout ou partie les inconvénients cités précédemment en proposant une pièce de micromécanique composite dont les parties utiles sont revêtues d'un matériau tribologiquement meilleur que le matériau micro-usinable utilisé ainsi qu'un procédé de fabrication de telles pièces qui comporte moins d'étapes.

A cet effet, l'invention se rapporte à un procédé de fabrication d'une pièce de micromécanique composite comportant les étapes suivantes :
a) se munir d'un substrat comportant une couche supérieure et une couche inférieure en matériau micro-usinable électriquement conductrices et solidarisées entre elles par une couche intermédiaire électriquement isolante ;
b) graver selon au moins un motif dans la couche supérieure jusqu'à la couche intermédiaire afin de former au moins une cavité dans le substrat ;
c) recouvrir la partie supérieure dudit substrat d'un revêtement électriquement isolant ;
d) graver de manière directionnelle ledit revêtement et ladite couche intermédiaire afin de limiter leur présence uniquement au niveau de chaque paroi verticale formée dans ladite couche supérieure ;
e) réaliser une électrodéposition en connectant l'électrode à la couche conductrice inférieure du substrat afin de former au moins une partie métallique de ladite pièce ;
f) libérer la pièce composite du substrat.

Ainsi, avantageusement selon l'invention, le dépôt de la couche tribologiquement meilleure que le matériau micro-usinable est entièrement intégrée au procédé de fabrication et non effectuée a posteriori de la fabrication de ladite pièce.

Conformément à d'autres caractéristiques avantageuses de l'invention :
- une pièce est montée après l'étape d) au-dessus de la couche supérieure afin de former au moins un évidement communiquant avec ladite au moins une cavité afin de former un deuxième niveau à ladite pièce ;
- le procédé comporte, avant l'étape e), l'étape g) : monter une tige dans ladite au moins une cavité afin de former un trou dans la future pièce composite ;
- l'étape b) comporte les phases h) : structurer au moins un masque de protection sur la couche conductrice supérieure, i) : réaliser une attaque anisotropique de ladite couche supérieure selon les parties non recouvertes par ledit au moins un masque de protection, j) : retirer ledit au moins masque de protection ;
- le procédé comporte, avant l'étape e), l'étape g) : monter une tige dans ladite au moins une cavité afin de former un trou dans la future pièce composite ;
- le procédé comporte, avant l'étape f), les étapes b') : graver selon un motif dans la couche inférieure jusqu'à ladite partie métallique afin de former au moins une deuxième cavité dudit substrat, c') : recouvrir la partie inférieure dudit substrat d'un deuxième revêtement électriquement isolant, e') : réaliser une électrodéposition en connectant l'électrode à la couche conductrice inférieure du substrat afin de finir la formation des parties métalliques de ladite pièce ;
- le procédé comporte, à la suite de l'étape c'), l'étape d') : graver de manière directionnelle ledit deuxième revêtement afin de découvrir uniquement le dessous de la couche inférieure ;
- une pièce est montée après l'étape d') afin de former au moins un évidement communiquant avec ladite au moins une deuxième cavité offrant un deuxième niveau supplémentaire à ladite pièce ;
- le procédé comporte, avant l'étape e'), l'étape g') : monter une tige dans ladite au moins une deuxième cavité de la couche inférieure afin de former un trou dans la future pièce composite ;
- l'étape b') comporte les phases h') : structurer au moins un masque de protection sur la couche conductrice inférieure, i') : réaliser une attaque anisotropique de ladite couche inférieure selon les parties non recouvertes par ledit au moins un masque de protection, j') : retirer le masque de protection ;
- plusieurs pièces de micromécanique composite sont fabriquées sur le même substrat.
- les couches conductrices comportent un matériau à base de silicium dopé.

L'invention se rapporte également à une pièce de micromécanique composite comportant une partie en silicium comprenant un ajourage destiné à recevoir une partie métallique **caractérisée en ce que** la partie en silicium est formée par du silicium dopé et comporte des parties verticales en dioxyde de silicium afin d'améliorer les qualités tribologiques dudit silicium dopé. Cette pièce peut avantageusement être utilisée pour transmettre des forces par sa partie en silicium revêtue de dioxyde de silicium en étant, par exemple, chassée au niveau de la partie métallique.

Conformément à d'autres caractéristiques avantageuses de l'invention :
- la partie métallique comporte une portion en saillie de ladite partie en silicium afin de former un niveau uniquement en métal au-dessus de la partie en silicium ;
- ladite partie en silicium coopère, à l'aide d'une couche en dioxyde de silicium, avec une deuxième partie en silicium ;
- la deuxième partie en silicium est formée par du silicium dopé et comporte des parties verticales en dioxyde de silicium afin d'améliorer les qualité tribologique dudit silicium dopé ;
- la deuxième partie en silicium comprend au moins un ajourage destiné à recevoir une deuxième partie métallique ;
- ladite deuxième partie métallique comporte une portion en saillie de ladite deuxième partie en silicium afin de former un niveau uniquement en métal au-dessous de la deuxième partie en silicium ;
- chaque partie métallique comporte un trou apte à chasser ladite pièce contre un pivot ;

Enfin, l'invention se rapporte également à une pièce d'horlogerie comportant une pièce de micromécanique composite selon l'une des variantes précédentes dont au moins une partie en silicium forme une roue ou une ancre d'échappement.

### Description sommaire des dessins

D'autres particularités et avantages ressortiront clairement de la description qui en est faite ci-après, à titre indicatif et nullement limitatif, en référence aux dessins annexés, dans lesquels :
- les figures 1 à 6 sont des représentations des étapes successives d'un procédé de fabrication d'une pièce de micromécanique selon un premier mode de réalisation de l'invention ;
- la figure 7 est une pièce de micromécanique selon un premier mode de réalisation de l'invention ;
- les figures 8 à 13 sont des représentations des étapes successives d'un procédé de fabrication d'une pièce de micromécanique selon un deuxième mode de réalisation de l'invention ;
- la figure 14 est un schéma fonctionnel d'un procédé de fabrication d'une pièce de micromécanique selon l'invention.

### Description détaillée des modes de réalisation préférés

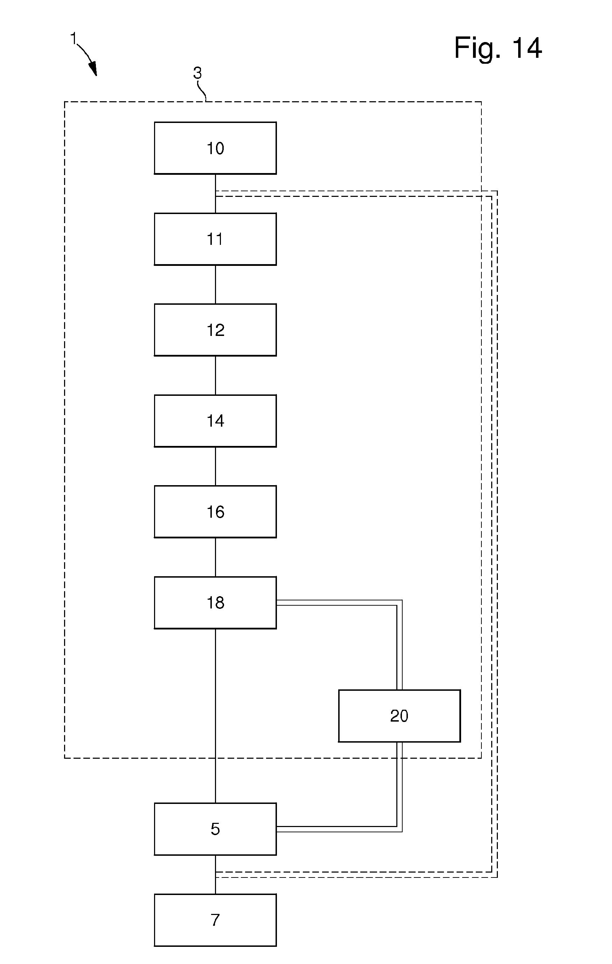

Comme visible à la figure 14, l'invention se rapporte à un procédé de fabrication 1 d'une pièce de micromécanique composite 41, 41'. Le procédé 1 comporte, préférentiellement, un procédé de préparation 3 suivi des étapes de galvanoplastie 5 et de libération 7 de la pièce composite 41, 41' ainsi formée.

Le procédé de préparation 3 comporte des étapes successives destinées à préparer un substrat 9, 9' en matériau au moins partiellement micro-usinable comme, préférentiellement, des matériaux à base de silicium. Le procédé de préparation 3 est destiné à faciliter la réception et la croissance de l'étape 5 de dépôt galvanique.

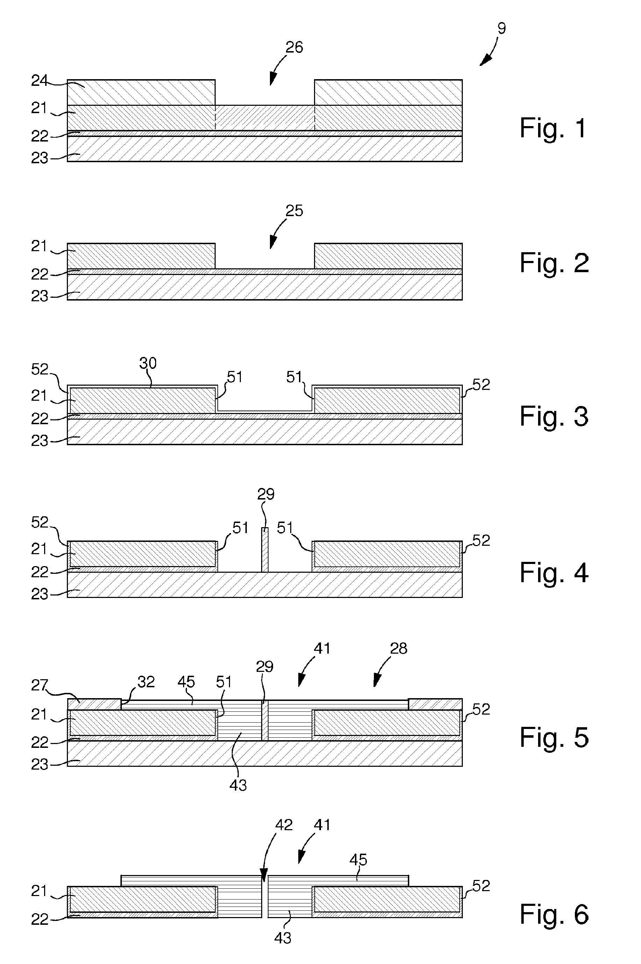

Une première étape 10 du procédé 3 consiste à se munir d'un substrat 9 comportant une couche supérieure 21 et une couche inférieure 23, en matériau micro-usinable électriquement conducteur, solidarisées entre elles par une couche intermédiaire 22 électriquement isolante comme illustré à la figure 1.

Préférentiellement, le substrat 9 est un S.O.I. (abréviation très connue provenant des termes anglais « Silicon On Isulator »). Ainsi, la couche intermédiaire 22 est préférentiellement en dioxyde de silicium. De plus, les couches supérieure 21 et inférieure 23 sont en silicium cristallin suffisamment dopé afin que lesdites couches soient électriquement conductrices.

Selon l'invention, le procédé 3 comporte une deuxième étape 11, consistant à structurer au moins un masque 24 de protection sur la couche conductrice supérieure 21 comme illustré à la figure 1. Comme visible également à la figure 1, le masque 24 comporte au moins un motif 26 qui ne recouvre pas la couche supérieure 21. Un tel masque 24 peut, par exemple, être obtenu par photolithographie à l'aide d'une résine photosensible du type positif ou négatif.

Dans une troisième étape 12, la couche supérieure 21 est gravée jusqu'à découvrir la couche intermédiaire 22. Selon l'invention, l'étape 12 de gravage comporte, de manière préférée, une attaque sèche anisotropique du type gravage ionique réactif profond (DRIE). L'attaque anisotropique est effectuée dans la couche supérieure 21 selon le motif 26 du masque 24.

Dans une quatrième étape 14, le masque 24 est retiré. Ainsi, comme visible à la figure 2, à la fin de la quatrième étape 14, la couche supérieure 21 est gravée sur toute son épaisseur d'au moins une cavité 25, permettant de former une partie en silicium d'au moins une pièce composite finale 41, 41 '.

Dans une cinquième étape 16, un revêtement 30 électriquement isolant est déposé en recouvrant l'ensemble supérieur du substrat 9 comme illustré à la figure 3. Préférentiellement, le revêtement 30 est obtenu par oxydation du dessus de la couche supérieure 21 gravée et de la couche intermédiaire 22. Comme visible à la figure 3, on obtient donc une couche de dioxyde de silicium aussi bien sur le dessus de la couche supérieure 21 et de la couche intermédiaire 22 mais également sur les parois verticales 51, 52 de la couche supérieure 21.

Selon une sixième étape 18, un gravage directionnel du revêtement 30 et de la couche intermédiaire 22 est réalisé. L'étape 18 est destinée à limiter la présence de couches isolantes uniquement au niveau de chaque paroi verticale formée dans la couche supérieure 21, c'est-à-dire les parois 51, 52 respectivement de l'extérieure de la future pièce composite 41, 41' et de ladite au moins une cavité 25. En réalisant cette étape 18 et comme illustré à la figure 4, on comprend que le fond de la cavité 25 découvre la couche inférieure 23 électriquement conductrice et le dessus de la couche supérieure 21 également conductrice.

Afin d'améliorer l'accrochage de la future galvanoplastie de l'étape 5, une couche d'accrochage sur le fond de chaque cavité 25 et/ou sur le dessus de la couche supérieure 21 peut être prévue. La couche d'accrochage pourrait alors consister en un métal comme de l'alliage CrAu.

De manière préférée, lors de la sixième étape 18, une tige 29 peut également être montée afin de former directement un trou d'axe 42, 42' de la pièce de micromécanique composite 41, 41' lors de l'étape 5 de galvanoplastie. Cela présente l'avantage non seulement de ne pas à avoir à usiner la pièce 41, 41' une fois la galvanoplastie terminée mais également de pouvoir réaliser n'importe quelle forme de section intérieure, de manière uniforme ou non, sur toute la hauteur du trou 42, 42'. Préférentiellement, la tige 29 est obtenue, par exemple, à l'aide d'un procédé de photolithographie d'une résine photosensible.

A la suite de l'étape 18, le procédé de préparation 3 est terminé et le procédé de fabrication 1 de la pièce de micromécanique composite se poursuit par les étapes de galvanoplastie 5 et de libération 7 de ladite pièce.

L'étape 5 de galvanoplastie est réalisée en connectant l'électrode de dépôt à la couche inférieure 23 afin de faire croître un dépôt électrolytique 33 dans la cavité 25.

Le procédé de fabrication 1 se termine par l'étape 7 dans laquelle la pièce formée par la couche supérieure 21 et la partie métallique déposée dans la cavité 25 est libérée du reste du substrat 9, c'est-à-dire de la couche inférieure 23 et de la tige 29. Selon ce mode de réalisation, on comprend que la pièce de micromécanique obtenue comporte un seul niveau de forme identique selon toute son épaisseur et pouvant comporter un trou d'axe.

Une telle pièce de micromécanique pourrait, par exemple, être une roue d'échappement, une ancre d'échappement ou même un pignon comportant une partie métallique au niveau de son trou d'axe apte à chasser ladite pièce de micromécanique. De plus, la paroi extérieure de la partie silicium comporte une couche de dioxyde de silicium aux caractéristiques plus avantageuses que celles de la partie en silicium 21 et offrant une précision géométrique de l'ordre du micromètre.

Selon une alternative à ce mode de réalisation illustré par un trait double à la figure 14, à la suite de l'étape 18, le procédé de préparation 3 comporte une étape supplémentaire 20 destinée à former au moins un deuxième niveau 45, 45' à la partie métallique 43, 43' comme illustré à la figure 5. Ainsi, le deuxième niveau 45, 45' est réalisé en montant une pièce 27, comportant des parois 32 électriquement isolantes, sur la couche supérieure 21 qui n'a pas été gravée lors de l'étape 12.

Préférentiellement, la pièce 27 ajoutée forme au moins un évidement 28 de section plus grande que les parties retirées selon le motif 26, par exemple, à l'aide d'un procédé de photolithographie d'une résine photosensible. Cependant, la pièce 27 pourrait également comporter un matériau à base de silicium préalablement gravé puis être solidarisée sur la couche conductrice 21.

Par conséquent, selon l'alternative du mode de réalisation ci-dessus, à la suite de l'étape 20, le procédé de préparation 3 est terminé et le procédé de fabrication 1 de la pièce de micromécanique composite 41 se poursuit par les étapes de galvanoplastie 5 et de libération 7 de ladite pièce du substrat 9.

L'étape 5 de galvanoplastie est réalisée en connectant l'électrode de dépôt à la couche inférieure 23 afin de faire croître dans un premier temps un dépôt électrolytique dans la cavité 25 puis, seulement dans un deuxième temps, dans l'évidement 28 comme illustré à la figure 5.

En effet, avantageusement selon l'invention, lorsque le dépôt électrolytique affleure de la partie supérieure de la cavité 25, il connecte électriquement la couche supérieure 21 (ou, éventuellement, sa couche d'accrochage) ce qui permet une croissance horizontale homogène du dépôt dans l'ensemble de l'évidement 28. Ainsi, l'invention permet la réalisation de pièces composites 41 comportant une première partie 43 en métal selon la même épaisseur que la couche supérieure 21 et une deuxième partie métallique 45 en saillie.

De manière avantageuse, la deuxième partie métallique 45 peut être à grand élancement, c'est-à-dire que la section de la cavité 25 peut être beaucoup plus petite que celle de l'évidement 28. En effet grâce au procédé 1, la partie 45 est fabriquée en évitant les problèmes de décollement y compris avec un matériau déposé comme du nickel - phosphore à, par exemple, 12% de phosphore. Cet effet avantageux est dû en partie à l'utilisation du silicium comme couches conductrices 21, 23 (et éventuellement leur couche d'accrochage) qui diminue les phénomènes de délamination aux interfaces.

Selon l'alternative du mode de réalisation ci-dessus, le procédé de fabrication 1 se termine par l'étape 7, dans laquelle la pièce 41 formée est libérée, c'est-à-dire que la pièce 27 et la tige 29 sont enlevées et la pièce 41 retirée du substrat 9.

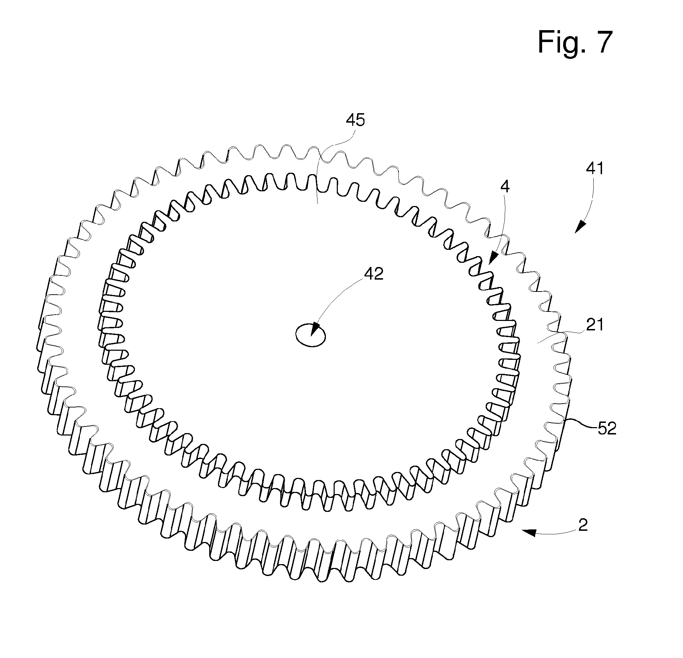

On comprend comme illustré aux figures 6 et 7 que la pièce de micromécanique composite 41 obtenue comporte deux niveaux, chacun de forme différente selon une épaisseur parfaitement indépendante et pouvant comporter un unique trou d'axe 42. Le premier niveau comporte ainsi la couche supérieure 21 dont les parois verticales 51, 52 sont recouvertes de dioxyde de silicium et dont la cavité interne 25 reçoit une première partie 43 du dépôt galvanique. Le deuxième niveau est uniquement réalisé par la deuxième partie métallique 45 s'étendant en prolongement de la première partie 43 et en saillie de la couche supérieure 21. Dans l'exemple illustré aux figures 6 et 7, on remarque que la deuxième partie 45 est également en recouvrement partiel de la couche supérieure 21.

Comme visible aux figures 6 et 7, la pièce de micromécanique 41 peut par conséquent avoir le même premier niveau que celui obtenu par le mode de réalisation sans l'étape 20 et ainsi comporter une précision géométrique de l'ordre du micromètre mais également un référencement idéal c'est-à-dire un positionnement parfait entre les deux niveaux. La pièce de micromécanique 41 peut dès lors former un mobile comportant une roue dentée 2 et un pignon 4 comme, par exemple, une roue d'échappement. Selon l'invention, la pièce de micromécanique obtenue n'est pas limitée à un mobile. En variante, il est parfaitement envisageable d'obtenir une ancre 2 avec des palettes monoblocs à revêtement de dioxyde de silicium comportant un dard 4.

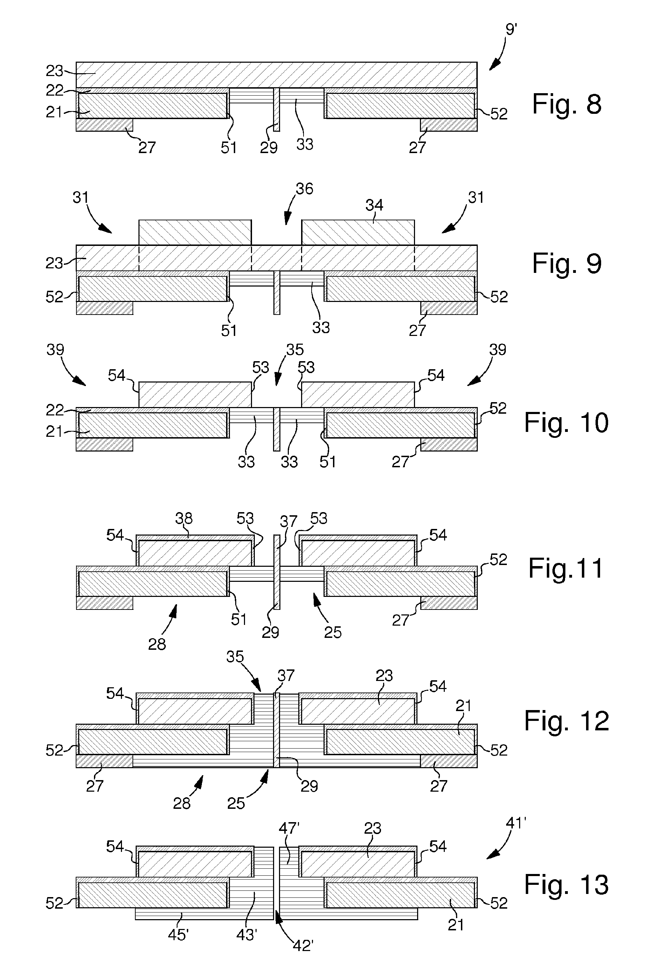

Selon un deuxième mode de réalisation du procédé 1 (illustrée en traits doubles discontinus à la figure 14) représentant pour partie une continuation du mode de réalisation déjà exposé. Comme illustré aux figures 8 à 13, il est ainsi possible d'appliquer le procédé 3 également à la couche inférieure 23 afin de rajouter au moins un ou deux autres niveaux supplémentaires à ladite pièce de micromécanique. Afin de ne pas surcharger les figures, un seul exemple est détaillé ci-dessus mais on comprend que la couche inférieure 23 peut également être transformée selon le mode de réalisation exposé ci-dessus avec, ou non, son alternative.

Les étapes du deuxième mode de réalisation restent identiques ou similaires au procédé 1 décrit ci-dessus jusqu'à l'étape 18 ou 20. Dans l'exemple illustré aux figures 8 à 13, on prendra comme point de départ du procédé 1, l'exemple du mode de réalisation avec l'alternative de l'étape 20 comme illustré à la figure 5.

Préférentiellement selon ce deuxième mode de réalisation, la couche inférieure 23 est destinée à être gravée afin de former au moins une deuxième cavité 35. Comme visible, de manière préférée entre la figure 5 et la figure 8, un dépôt 33 a été réalisé dans une partie de la première cavité 25 afin de fournir une couche de départ pour la deuxième galvanoplastie. Préférentiellement, ce dépôt 33 est effectué en commençant l'étape 5 jusqu'à une épaisseur prédéterminée. Cependant, ce dépôt 33 peut être effectué selon un autre procédé.

Comme illustré par des traits double discontinus à la figure 14 et les figures 8 à 13, le deuxième mode de réalisation du procédé 1 applique à la couche inférieure 23, les étapes 11, 12, 14, 16 et 18 du premier mode de réalisation du procédé 3 expliqué ci-dessus.

Ainsi selon le deuxième mode de réalisation, le procédé 3 comporte une nouvelle étape 11, consistant à structurer au moins un masque 34 sur la couche conductrice inférieure 23 du substrat 9' comme illustré à la figure 9. Comme visible également à la figure 9, le masque 34 comporte au moins un motif 36 et 31 qui ne recouvre pas la couche inférieure 23. Un tel masque 34 peut, par exemple, être obtenu par photolithographie à l'aide d'une résine photosensible.

Ensuite, à la nouvelle étape 12, la couche 23 est gravée selon les motifs 36 et 31 jusqu'à découvrir le dépôt 33 électriquement conducteur et la couche intermédiaire 22. Puis le masque de protection 34 est retiré lors d'une nouvelle étape 14. Ainsi, comme visible à la figure 10, à la fin de l'étape 14, la couche inférieure 23 est gravée sur toute son épaisseur d'au moins une cavité 35 et 39.

Dans une nouvelle étape 16, un revêtement 38 électriquement isolant est déposé en recouvrant l'ensemble inférieur du substrat 9' comme illustré à la figure 11. Préférentiellement, le revêtement 38 est obtenu par dépôt d'un dioxyde de silicium sur le dessous de la couche inférieure 23, par exemple, à l'aide d'un dépôt physique en phase vapeur.

Préférentiellement, dans notre exemple des figures 8 à 13, une nouvelle étape 18 n'est effectuée que pour enlever la couche d'oxyde présente dans le fond de ladite au moins une cavité 35. Cependant, dans le cas où un deuxième niveau est souhaité, un gravage directionnel de toutes les partie horizontales du revêtement 38 est réalisé. La nouvelle étape 18 serait alors destinée à limiter la présence de couche isolante uniquement au niveau de chaque paroi verticale 53, 54 formée dans la couche inférieure 23, c'est-à-dire les parois de l'extérieure de la future pièce 41' et de ladite au moins une cavité 35..

Lors de la nouvelle étape 18, comme expliqué précédemment, une tige 37 peut être montée afin de former directement le trou d'axe 42' de la pièce de micromécanique 41' lors de l'étape 5 de galvanoplastie avec les mêmes avantages que cités précédemment.

Dans le deuxième mode de réalisation du procédé 1, à la suite de l'étape 18, le procédé de préparation 3 est terminé et le procédé de fabrication 1 de la pièce de micromécanique se poursuit par les étapes de galvanoplastie 5 et de libération 7 de la pièce composite 41'. Préférentiellement, si les tiges 29 et 37 sont formées respectivement dans les cavités 25 et 35, elles sont alignées. De plus, la tige 37 est, de manière préférée, obtenue à l'aide d'un procédé de photolithographie d'une résine photosensible.

A la suite de la nouvelle étape 18 (ou 20), l'étape 5 de galvanoplastie est réalisée en connectant l'électrode de dépôt à la couche inférieure 23 afin de faire croître un dépôt électrolytique dans la cavité 35 mais également continuer la croissance du dépôt dans la cavité 25, puis, seulement dans un deuxième temps, dans l'évidement 28 comme illustré à la figure 12. Dans le cas de l'exemple illustré à la figure 12 afin de connecter ladite électrode, il est ainsi par exemple possible de graver une partie de la couche de dioxyde de silicium 38 contenue au-dessous de la surface supérieure 23 afin d'y accéder. Il peut également être envisager de connecter directement le dépôt 33.

Le procédé de fabrication 1 selon le deuxième mode de réalisation se termine par l'étape 7, dans laquelle la pièce 41' est libérée, c'est-à-dire que la pièce 27 et les tiges 29, 37 sont enlevées et la pièce 41' retirée du substrat 9'.

Selon ce deuxième mode de réalisation, on comprend comme illustré à la figure 13 que la pièce de micromécanique composite 41' obtenue comporte au moins trois niveaux, chacun de forme différente selon une épaisseur parfaitement indépendante avec un trou d'axe unique 42'. Le premier niveau comporte ainsi la couche supérieure 21 dont les parois verticales 51, 52 sont recouvertes de dioxyde de silicium dont la cavité interne 25 reçoit une première partie 43' du dépôt galvanique. Le deuxième niveau est uniquement réalisé par la deuxième partie métallique 45' s'étendant en prolongement de la première partie 43' et en saillie de la couche supérieure 21. Enfin, le troisième niveau est formé par la couche inférieure 23 dont les parois verticales 53, 54 sont recouvertes de dioxyde de silicium et dont la cavité interne 35 reçoit une troisième partie 47' du dépôt galvanique.

La pièce de micromécanique 41' peut par conséquent avoir les deux mêmes premiers niveaux que celui obtenu par le premier mode de réalisation avec l'étape 20. Une telle pièce de micromécanique 41' pourrait, par exemple, être une roue d'échappement coaxiale 21 - 52, 23 - 54 avec son pignon 45' ou un mobile à trois niveaux de dentures 21 - 52, 23 - 54, 45' comportant une précision géométrique de l'ordre du micromètre mais également un référencement idéal c'est-à-dire un positionnement parfait entre lesdits niveaux.

Bien entendu, la présente invention ne se limite pas à l'exemple illustré mais est susceptible de diverses variantes et modifications qui apparaîtront à l'homme de l'art. Ainsi, plusieurs pièces de micromécanique composite 41, 41' peuvent être fabriquées sur le même substrat 9, 9' afin de réaliser une production en série de pièces de micromécanique 41, 41' qui ne sont pas forcément identiques entre elles. De même, on peut également envisager changer des matériaux à base de silicium par de l'alumine cristallisée ou de la silice cristallisée ou carbure de silicium. Il est également envisageable que les dépôts isolants 30 et/ou 38 soient de nature différente et/ou qu'ils soient déposés chacun selon des méthodes différentes que celles exposées ci-dessus.

## Revendications

1. Procédé de fabrication (1) d'une pièce de micromécanique composite (41, 41') comportant les étapes suivantes :
a) se munir (10) d'un substrat (9, 9') comportant une couche supérieure (21) et une couche inférieure (23) en matériau micro-usinable électriquement conductrices et solidarisées entre elles par une couche intermédiaire (22) électriquement isolante ;
b) graver selon au moins un motif (26) dans la couche supérieure (21) jusqu'à la couche intermédiaire (22) afin de former au moins une cavité (25) dans le substrat (9, 9') ;
c) recouvrir (16) la partie supérieure dudit substrat d'un revêtement (30) électriquement isolant ;
d) graver (18) de manière directionnelle ledit revêtement et ladite couche intermédiaire afin de limiter leur présence uniquement au niveau de chaque paroi verticale (51, 52) formée dans ladite couche supérieure ;
e) réaliser (5) une électrodéposition en connectant l'électrode à la couche conductrice inférieure (23) du substrat (9, 9') afin de former au moins une partie métallique (33, 43, 43') de ladite pièce ;
f) libérer la pièce composite (41, 41') du substrat (9, 9').

2. Procédé (1) selon la revendication 1, **caractérisé en ce qu'**une pièce (27) est montée après l'étape d) au-dessus de la couche supérieure (21) afin de former au moins un évidement (28) communiquant avec ladite au moins une cavité afin de former un deuxième niveau (45, 45') à ladite pièce.

3. Procédé (1) selon la revendication 1 ou 2, **caractérisé en ce qu'**il comporte, avant l'étape e), l'étape suivante :
g) monter une tige (29) dans ladite au moins une cavité afin de former un trou (42, 42') dans la future pièce composite (41, 41').

4. Procédé (1) selon l'une des revendications précédentes, **caractérisé en ce que** l'étape b) comporte les phases suivantes :
h) structurer (11) au moins un masque (24) de protection sur la couche conductrice supérieure (21) ;
i) réaliser (12) une attaque anisotropique de ladite couche supérieure selon les parties (26) non recouvertes par ledit au moins un masque de protection ;
j) retirer (14) ledit au moins masque de protection.

5. Procédé (1) selon l'une des revendications précédentes, **caractérisé en ce qu'**il comporte, avant l'étape f), les étapes suivantes :
b') graver selon un motif (36, 31) dans la couche inférieure (23) jusqu'à ladite partie métallique (33, 43, 43') afin de former au moins une deuxième cavité (35) dudit substrat ;
c') recouvrir la partie inférieure (23) dudit substrat d'un deuxième revêtement (38) électriquement isolant ;
e') réaliser une électrodéposition en connectant l'électrode à la couche conductrice inférieure (23) du substrat (9') afin de finir la formation des parties métalliques (33, 43', 45', 47') de ladite pièce.

6. Procédé (1) selon la revendication 5, **caractérisé en ce qu'**il comporte, à la suite de l'étape c'), l'étape suivante :
d')graver (18) de manière directionnelle ledit deuxième revêtement afin de découvrir uniquement le dessous de la couche inférieure (23).

7. Procédé (1) selon la revendication 6, **caractérisé en ce qu'**une pièce est montée après l'étape d') afin de former au moins un évidement communiquant avec ladite au moins une deuxième cavité offrant un deuxième niveau supplémentaire à ladite pièce.

8. Procédé (1) selon l'une des revendications 5 à 7, **caractérisé en ce qu'**il comporte, avant l'étape e'), l'étape suivante :
g') monter une tige (37) dans ladite au moins une deuxième cavité (35) de la couche inférieure (23) afin de former un trou (42') dans la future pièce composite (41').

9. Procédé (1) selon l'une des revendications 5 à 8, **caractérisé en ce que** l'étape b') comporte les phases suivantes :
h') structurer au moins un masque (34) de protection sur la couche conductrice inférieure (23) ;
i') réaliser une attaque anisotropique de ladite couche inférieure selon les parties (36, 31) non recouvertes par ledit au moins un masque de protection ;
j') retirer le masque de protection (34).

10. Procédé (1) selon l'une des revendications précédentes, **caractérisé en ce que** plusieurs pièces de micromécanique composite (41, 41') sont fabriquées sur le même substrat (9, 9').

11. Procédé (3) selon l'une des revendications précédentes, **caractérisé en ce que** les couches conductrices (21, 23) comportent un matériau à base de silicium dopé.

12. Pièce de micromécanique composite (41, 41') comportant une partie (21) en silicium comprenant un ajourage (25) destiné à recevoir une partie métallique (43, 43') **caractérisée en ce que** la partie (21) en silicium est formée par du silicium dopé et comporte des parties verticales (51, 52) en dioxyde de silicium afin d'améliorer les qualités tribologiques dudit silicium dopé.

13. Pièce de micromécanique selon la revendication 12, **caractérisée en ce que** la partie métallique (43, 43') comporte une portion (45, 45') en saillie de ladite partie en silicium afin de former un niveau uniquement en métal au-dessus de la partie (21) en silicium.

14. Pièce de micromécanique selon la revendication 12 ou 13, **caractérisée en ce que** ladite partie en silicium coopère, à l'aide d'une couche (22) en dioxyde de silicium, avec une deuxième partie (23) en silicium.

15. Pièce de micromécanique selon la revendication 14, **caractérisée en ce que** la deuxième partie en silicium (23) est formée par du silicium dopé et comporte des parties verticales (53, 54) en dioxyde de silicium afin d'améliorer les qualité tribologique dudit silicium dopé.

16. Pièce de micromécanique selon la revendication 14 ou 15, **caractérisée en ce que** la deuxième partie (23) en silicium comprend au moins un ajourage (35) destiné à recevoir une deuxième partie métallique (47').

17. Pièce de micromécanique selon la revendication 16, **caractérisée en ce que** ladite deuxième partie métallique comporte une portion en saillie de ladite deuxième partie en silicium afin de former un niveau uniquement en métal au-dessous de la deuxième partie en silicium (23).

18. Pièce de micromécanique selon l'une des revendications 12 à 17, **caractérisée en ce que** chaque partie métallique (43, 43', 45, 45', 47') comporte un trou (42, 42') apte à chasser ladite pièce contre un pivot.

19. Pièce d'horlogerie **caractérisée en ce qu'**elle comprend au moins une pièce de micromécanique composite conforme à l'une des revendications 12 à 18.

20. Pièce d'horlogerie selon la revendication 19, **caractérisée en ce qu'**au moins une partie en silicium de la pièce de micromécanique forme une roue d'échappement.

21. Pièce d'horlogerie selon la revendication 19, **caractérisée en ce qu'**au moins une partie en silicium de la pièce de micromécanique forme une ancre d'échappement.
